# EUROPEAN PATENT SPECIFICATION

(11) **EP 1 518 150 B1**
(45) Date of publication and mention of the grant of the patent: **29.03.2006**
(21) Application number: 03742217.7
(22) Date of filing: 25.06.2003
(51) Int. Cl.: G03F 1/08

(54) **METHOD OF RETICLE FABRICATION USING AN AMORPHOUS CARBON LAYER**
METHODE ZUR HERSTELLUNG EINER PHOTOMASKE UNTER EINSATZ EINER AMORPHEN KOHLENSTOFFSCHICHT
METHODE DE FABRICATION DE RETICULE UTILISANT UNE COUCHE DE CARBONE AMORPHE

(30) Priority: 03.07.2002 US 190138
(43) Date of publication of application: 30.03.2005
(73) Proprietor: ADVANCED MICRO DEVICES, INC., Sunnyvale, California 94088-3453 (US)
(72) Inventor: TABERY, Cyrus, E., Sunnyvale, CA 94089 (US); LYONS, Christopher, F., Fremont, CA 94539 (US)
(74) Representative: Wright, Hugh Ronald
(86) International application number: PCT/US2003/020113
(87) International publication number: WO 2004/006014

(56) References cited:
- EP-A- 1 154 468
- US-A- 4 704 342
- US-A- 5 998 100
- US-A- 6 127 263
- US-A1- 2003 165 747
- PATENT ABSTRACTS OF JAPAN vol. 012, no. 079 (P-676), 12 March 1988 (1988-03-12) & JP 62 217245 A (FUJITSU LTD), 24 September 1987 (1987-09-24)

## Description

### FIELD OF THE INVENTION

The present disclosure relates generally to lithography and methods of lithographic patterning. More particularly, the present disclosure relates to a method of using an amorphous carbon layer for improved reticle or mask fabrication.

### BACKGROUND OF THE INVENTION

In general, a reticle or mask is a lithographic tool which contains a pattern that is transferred to a wafer. In the field of integrated circuits, a reticle can be classified as a plate that contains the pattern for one or more die but is not large enough to transfer a wafer sized pattern all at once. In the field of integrated circuits, a mask can be classified as a plate that contains a pattern large enough to pattern a whole wafer at a time. The pattern for reticles and masks can be formed of opaque and non-opaque areas disposed on a glass plate (e.g., fused silica, soda-lime glass, borosilicate glass, fluorinated silicone dioxide, and quartz). The opaque areas often include chromium, emulsion, ion oxide, and/or chromium oxide. Alternatively, the pattern can be manifested on a conventional phase shift mask. Conventional phase shift masks can include opaque areas and phase shift areas which define the pattern.

Semiconductor fabrication techniques often utilize a mask or reticle. Radiation is provided through or reflected off the mask or reticle to form an image on a semiconductor wafer. The wafer is positioned to receive the radiation transmitted through or reflected off the mask or reticle. The image on the semiconductor wafer corresponds to the pattern on the mask or reticle. The radiation can be light, such as ultraviolet light, vacuum ultraviolet light, etc. The radiation can also be x-ray radiation, e-beam radiation, etc.

Generally, the image is focused on the wafer to pattern a layer of material, such as, photoresist material. The photoresist material can be utilized to define doping regions, deposition regions, etching regions, or other structures associated with an integrated circuit (IC). The photoresist material can also define conductive lines or conductive pads associated with metal layers of an integrated circuit. Further, the photoresist material can define isolation regions, transistor gates, or other transistor structures and elements.

A conventional lithographic system is generally utilized to project the image to the wafer. For example, the conventional lithographic system includes a source of radiation, an optical system, and a reticle or photomask. The source of radiation provides radiation through the optical system and through or off of the mask or reticle.

The pattern image on the reticle is stepped and repeated to expose an entire substrate, such as, a wafer, while the pattern on a photomask or mask is transmitted to an entire wafer. However, as used in this application, the terms reticle, photomask, and mask are interchangeable unless specifically described otherwise. The photomask can be positive or negative (clear-field or dark-field tools).

According to a conventional mask patterning process, the glass substrate is polished in a multiple step process. The polished substrate is cleaned and inspected for defects. After inspecting the glass substrates, the glass substrates are coated with an opaque material, (e.g., an absorbing layer). The glass substrates can be coated in a sputter deposition process.

The opaque material is selectively etched according to a lithographic process. The opaque material is coated with a resist material. The resist material is patterned via an optical pattern generator. A conventional optical pattern generator utilizes shutters, light sources, optical components, and movable stages to produce the appropriate optical pattern on the resist material. The resist material is then removed in accordance with the optical pattern. The opaque material is removed in accordance with the remaining resist material. The opaque material can be removed by wet etching. Thus, the absorbing material is patterned or etched in accordance with the image desired to be formed on the substrate (e.g., the image provided by the optical pattern generators).

Manufacturing masks and reticles is time consuming and costly. Further, the equipment including the optical pattern generators required to manufacture the masks and reticles is expensive. Masks and reticles must be manufactured for each image to be transferred on the wafer.

Traditionally, reticle fabrication processes have not improved as quickly as wafer fabrication processes. As 0.1 micron lithography is desired, the precision and accuracy of the reticle pattern become more and more important. Heretofore, conventional reticles have several problems, which affect accuracy and precision of the reticle pattern. For example, poor selectivity between opaque material (i.e., the absorber) and the photoresist used to pattern the reticle can adversely affect accuracy and precision. Poor selectivity can result in improperly sized patterns, poor edges on patterned features, less than complete removal of the opaque material in unwanted areas, etc. Further, problems exist with respect to resist thickness, substrate damage, and reflectivity during reticle patterning and pattern transfer to the reticle. Further still, photoresist layers used to pattern the reticle can also be poisoned by the CrON material used as the opaque material.

Thus, there is a need to use an amorphous carbon layer to improve reticle fabrication. Further, there is a need to have a double selectivity switch using a SiON and amorphous carbon hard mask. Even further, there is a need to improve the accuracy and precision of reticles and masks and the process that fabricate reticles and masks.

### SUMMARY OF THE INVENTION

An exemplary embodiment relates to a method of using an amorphous carbon layer for improved reticle fabrication. The method can include depositing a stack of layers including a substrate, an absorber, a transfer layer, an anti-reflective coating (ARC) layer, and a photoresist layer, patterning the photoresist layer, and etching the ARC layer and the transfer layer. The method also includes etching the absorber layer and removing the transfer layer. The transfer layer includes amorphous carbon.

Another exemplary embodiment relates to a method of reticle fabrication. The method can include patterning a photoresist layer located above a SiON layer and an amorphous carbon layer, etching the SiON layer and the amorphous carbon layer using the patterned photoresist layer as a mask and exposing a metal containing layer disposed below the amorphous carbon layer. The method also includes etching the metal containing layer using the amorphous carbon layer as a mask, and removing the amorphous carbon layer.

Another exemplary embodiment relates to a method of using an amorphous carbon transfer layer for improved reticle fabrication. The method can include depositing a stack of layers including a substrate, an absorber, a transfer layer, an anti-reflective coating (ARC) layer, and a photoresist layer, and forming an aperture in the photoresist layer, the ARC layer, the transfer layer, and the absorber layer. The aperture has a first dimension. The method further includes removing layers above the absorber layer.

Other principle features and advantages of the invention will become apparent to those skilled in the art upon review of the following drawings, the detailed description, and the appended claims.

### BRIEF DESCRIPTION OF THE DRAWINGS

The exemplary embodiments of the disclosure will hereafter be described with reference to the accompanying drawings, wherein like numerals denote like elements, and:
FIGURE 1 is a flow diagram for a process of fabricating a reticle and utilizing it in a lithographic fabrication process in accordance with an exemplary embodiment;
FIGURE 2 is a schematic cross-sectional view representation of a portion of a reticle, showing a stack application step in accordance with an exemplary embodiment;
FIGURE 3 is a schematic cross-sectional view representation of the portion of the reticle of FIGURE 2, showing a photoresist patterning step;
FIGURE 4 is a schematic cross-sectional view representation of the portion of the reticle of FIGURE 1, showing an antireflective coating (ARC) etching step;
FIGURE 5 is a schematic cross-sectional view representation of the portion of the reticle of FIGURE 2, showing an amorphous carbon etching step;
FIGURE 6 is a cross-sectional view representation of the portion of the reticle of FIGURE 2, showing an absorber etching step; and
FIGURE 7 is a schematic cross-sectional view representation of the portion of the reticle of FIGURE 2, showing an amorphous carbon removal step.

### DETAILED DESCRIPTION OF EXEMPLARY EMBODIMENTS

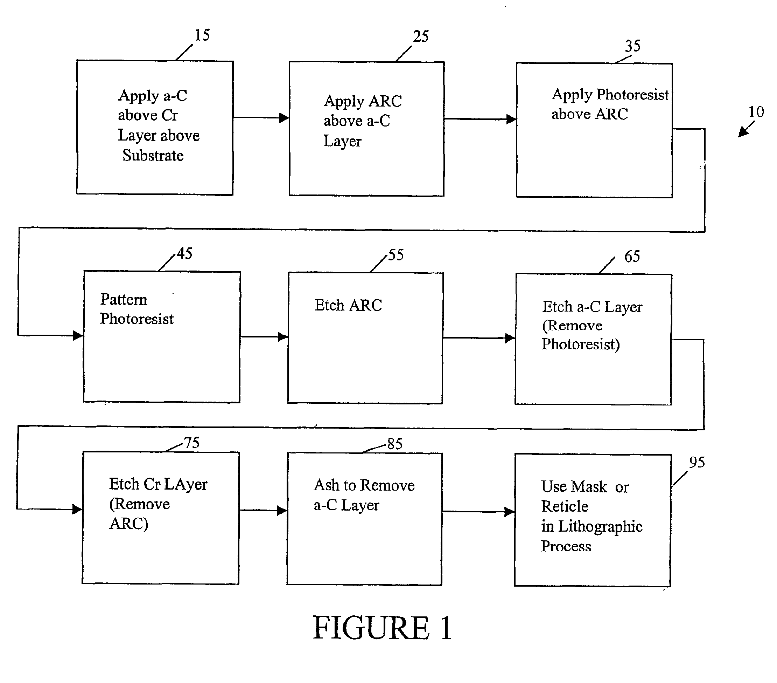

FIGURE 1 illustrates a flow diagram 10 of an exemplary process of fabricating a reticle and utilizing it in a lithographic fabrication process. Flow diagram 10 illustrates by way of example some steps that may be performed. Additional steps, fewer steps, or combinations of steps may be utilized in various different embodiments.

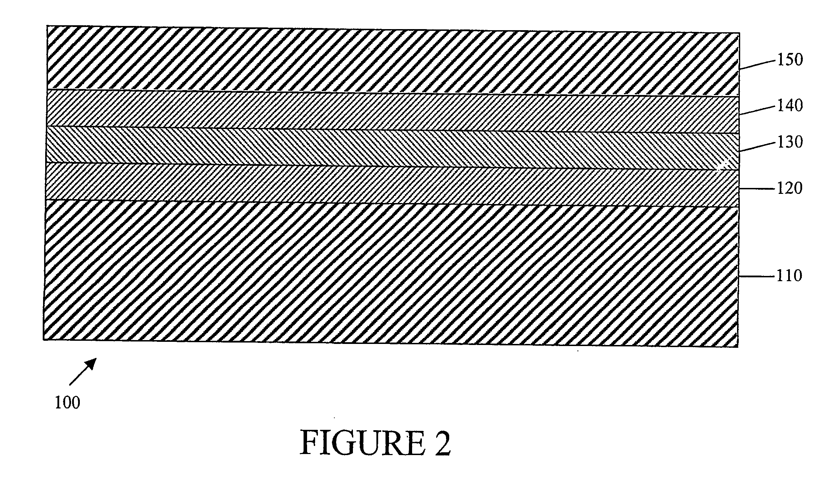

In an exemplary embodiment, a step 15 is performed in which an amorphous carbon layer is applied above a chromium layer which is applied above a substrate. A stack application step is described below with reference to FIGURE 2. In a step 25, an anti-reflective coating (ARC) is applied above the amorphous carbon layer. In a step 35, a photoresist layer is applied above the ARC layer.

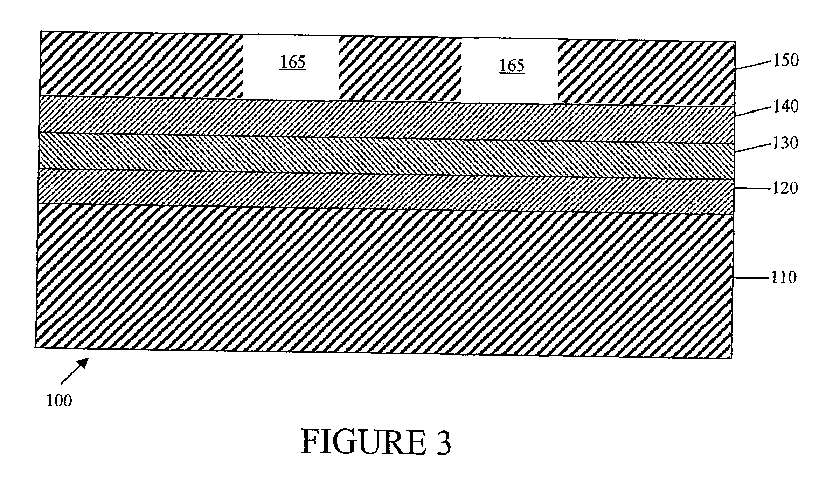

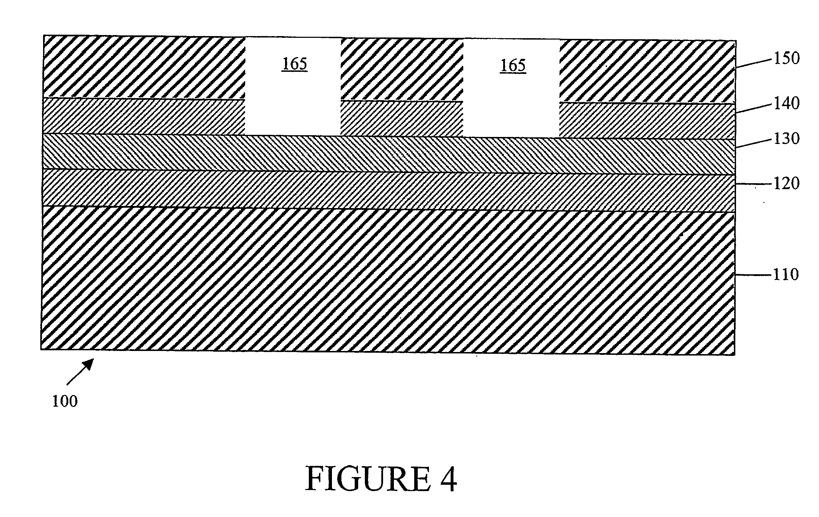

In a step 45, the photoresist layer is patterned. The photoresist layer can be patterned in a variety of different ways, such as, electron beam lithography, laser raster scanning lithography (laser pattern generator) or via conventional projection lithography (projection lithography is not typical for reticles). One photoresist patterning step is described below with reference to FIGURE 3. In a step 55, the ARC layer is etched according to the patterned photoresist layer. The ARC layer can be etched using a variety of different techniques, such as wet etch or plasma etching or reactive ion etch (RIE). One ARC etching step is described with reference to FIGURE 4.

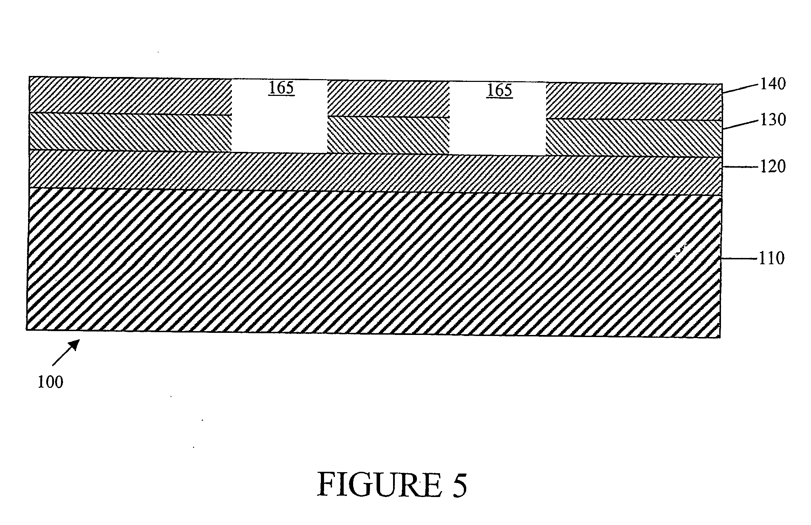

In a step 65, the amorphous carbon layer is etched in a process that simultaneously removes the patterned photoresist layer. The amorphous carbon layer can be etched using a variety of different techniques, such as RIE, plasma or wet etch, typically oxygen plasma. Alternatively, the patterned photoresist layer is removed before or after the amorphous carbon layer is etched. One amorphous carbon layer etching step is described below with reference to FIGURE 5.

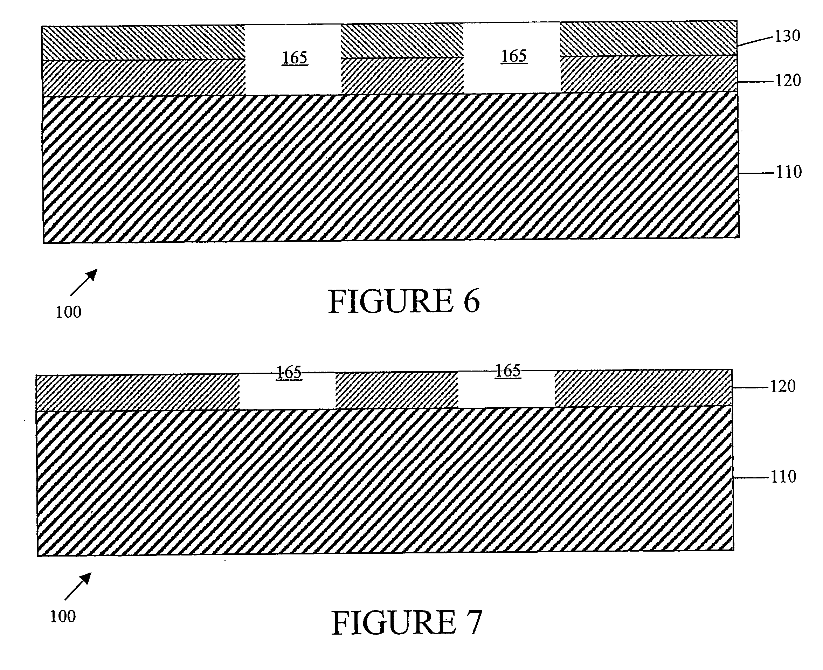

In a step 75, the chromium layer is etched while simultaneously the ARC layer is removed. A variety of techniques can be used to etch the chromium layer and remove the ARC layer, such as wet etch or RIE or plasma etching (involving, for example Cl₂ or O₂ plasma). Alternatively, the ARC layer is removed before or after the chromium layer is etched. One etching technique is described below with reference to FIGURE 6.

In a step 85, an ashing procedure is used to remove the amorphous carbon layer. A variety of techniques may be used to remove the amorphous carbon layer, such as RIE, plasma or wet etch involving, for example oxygen plasma. One amorphous carbon removal step is described below with reference to FIGURE 7. In a step 95, the mask or reticle formed after steps 15-85 are performed can be used in a lithographic process.

Referring to FIGURE 2, a portion 100 of a reticle includes a substrate 110, an absorber layer 120, a transfer layer 130, an anti-reflective coating (ARC) layer 140, and a photoresist layer 150. In an exemplary embodiment, substrate 110 can be a silicon dioxide (SiO₂) substrate, absorber layer 120 can be a chromium (Cr) layer, transfer layer 130 can be an amorphous carbon layer, and ARC layer 140 can be a silicon oxynitride (SiON) layer.

Absorber layer 120, transfer layer 130, ARC layer 140, and photoresist layer 150 can be deposited over substrate 110 using a variety of different deposition techniques. For example, chemical vapor deposition (CVD) or physical vapor deposition (PVD) can be used for deposition processes. In alternative embodiments, substrate 110 can be a fluorinate silicon dioxide, fused silica, soda-lime glass, borosilicate glass, or quartz. Absorber layer 120 can be a metal-containing layer or other layers suitable for patterning light.

By way of example, absorber layer 120 can have a thickness of 20-200 nm, transfer layer 130 can have a thickness of 5-200 nm, ARC layer 140 can have a thickness of 0-200 nm (no ARC could be used if an e-beam is used (no reflections), and photoresist layer 150 can have a thickness of 100-400 nm. As described below, photoresist layer 150 is only needed through the etching of ARC layer 140. As such, less resist thickness is required and resolution is improved.

The thicknesses of absorber layer 120 and transfer layer 130 can be tuned to optimize or minimize the reflectivity of the interface between photoresist layer 150 and ARC layer 140 for optical laser reticle pattern generators, such as the ALTA 3700™ and ALTA 4000™. Selecting thicknesses to minimize reflectivity as such can reduce or remove standing waves and improve critical dimension (CD) control.

As an example, the optical laser reticle pattern generator ALTA 4000™ uses a wavelength of 257 nm as well as chemically amplified resists. Resist poisoning can be a drawback to this reticle pattern generator. However, portion 100 configured using a double selectivity switch of absorber layer 120 and transfer layer 130, helps to avoid resist poisoning. For example, layers 130 and 140 can protect layer 150 from poisoning by layer 120.

FIGURE 3 illustrates portion 100 after a patterning step. In an exemplary embodiment, photoresist layer 150 is patterned to have apertures 165. This patterning can be performed using any of a variety of patterning techniques or patterning equipment, such as electron beam pattern generator (JEOL JBX 9000™ or Mebes 5000™) or a laser pattern generator (Alta 3700 or Omega 6000™).

FIGURE 4 illustrates portion 100 after an etching step. Once photoresist layer 150 is patterned, an etching process is provided to etch ARC layer 140. The etching process extends apertures 165 through ARC layer 140.

FIGURE 5 illustrates portion 100 after a second etching step. An etching process is provided to extend apertures 165 through transfer layer 130. During the etching of transfer layer 130, photoresist layer 150 is removed. Accordingly, in one advantageous step 65, layer 150 can be simultaneously removed when layer 130 is selectively etched. Alternatively, layer 150 can be separately removed before or after layer 130 is selectively etched.

FIGURE 6 illustrates portion 100 after a third etching step. In an exemplary embodiment, absorber layer 120 is etched to extend aperture 165 in transfer layer 130 through absorber layer 120. Along with the etching of absorber layer 120, ARC layer 140 is removed. Accordingly, in one advantageous step 75, layer 140 is simultaneously removed as layer 120 is selectively etched. Alternatively, layer 140 can be separately removed before or after layer 120 is selectively etched. The etching process can include an etch using wet etching chemistries, such as buffered oxide etch, hot phosphoric acid or plasma etching or RIE.

FIGURE 7 illustrates portion 100 after a removal step. In an exemplary embodiment, transfer layer 130 is removed using an oxygen plasma ash. In general, ashing is a process of removing certain layers, such as photoresist, amorphous carbon, or other layers, using an oxygen plasma or ultraviolet light generated ozone. Ashing produces no chemical waste because the removed layer is volatilized into N₂, O₂, CO and CO₂ gases.

Advantageously, absorber layer 120 is left clean after ashing away of transfer layer 130. Further, the method described with reference to the FIGURES can be used in the fabrication of an attenuating phase shifting mask. With an attenuating phase shifting mask, an amorphous carbon transfer layer used as described herein can protect a chrome layer during etching of a molybdenum silicide layer.

While the exemplary embodiments illustrated in the FIGURES and described above are presently preferred, it should be understood that these embodiments are offered by way of example only. Other embodiments may include, for example, different materials used as absorber layers to interact with the amorphous carbon transfer layer. The invention is not limited to a particular embodiment, but is defined by the appended claims.

## Claims

1. A method of fabricating a reticle, the method comprising:
depositing (15, 25, 35) a stack of layers including a substrate (110), an absorber (120), a transfer layer (130), optionally an anti-reflective coating (ARC) layer (140), and a photoresist layer (150);
patterning (45) the photoresist layer (150);
etching (55, 65) the ARC layer (140) and the transfer layer (130);
etching (75) the absorber layer (120); and
removing (85) the transfer layer (130), the transfer layer (130) including amorphous carbon.

2. The method of claim 1, wherein etching (55, 65) the ARC layer (140) and the transfer layer (130) includes removing the photoresist layer (150).

3. The method of claim 1, wherein etching (75) the absorber layer (120) includes removing the ARC layer (140).

4. The method of claims 1, 2 or 3 further **characterized in that** removing the amorphous carbon includes an O₂ plasma ash.

5. The method of claim 1, wherein the transfer layer (130) has a thickness of 5 to 200 nm.

6. The method of claim 1 further comprising:
patterning (45) the photoresist layer (150) located above the ARC layer (140), the ARC layer being an SiON layer, and the transfer layer (130), the transfer layer being an amorphous carbon layer (130);
etching (55, 65) the SiON layer (140) and the amorphous carbon layer (130) using the patterned photoresist layer (150) as a mask and exposing a metal containing layer(120) disposed below the amorphous carbon layer (130), the metal containing layer (120) being the absorber (120);
etching (75) the metal containing layer (120) using the amorphous carbon layer (130) as a mask; and
removing (85) the amorphous carbon layer (130).

7. The method of claim 6, wherein etching (55, 65) the SiON layer (140) and the amorphous carbon layer (130) using the patterned photoresist layer (150) as a mask and exposing a metal containing layer (120) disposed below the amorphous carbon layer (130) includes removing the photoresist layer (150) during the etching (75) of the amorphous carbon layer (130).

8. The method of claim 6, wherein the photoresist layer (150) has a thickness of 400 nm.

9. The method of claim 6, wherein the amorphous carbon layer (130) has a thickness of approximately between 30 nm and 100 nm.

10. The method of claim 6, wherein etching (75) the metal containing layer (120) using the amorphous carbon layer (130) as a mask includes removing the SiON layer (140).

## Revendications

1. Procédé de fabrication d'un réticule, le procédé consistant à :
déposer (15, 25, 35) un empilement de couches incluant un substrat (110), un absorbeur (120), une couche de transfert (130), facultativement une couche de revêtement anti-reflet (ARC) (140), et une couche de résine photosensible (150) ;
configurer (45) la couche de résine photosensible (150);
graver (55, 65) la couche ARC (140) et la couche de transfert (130) ;
graver (75) la couche d'absorbeur (120) ; et
éliminer (85) la couche de transfert (130), la couche de transfert (130) incluant du carbone amorphe.

2. Procédé selon la revendication 1 dans lequel graver (55, 65) la couche ARC (140) et la couche de transfert (130) inclut d'éliminer la couche de résine photosensible (150).

3. Procédé selon la revendication 1 dans lequel graver (75) la couche d'absorbeur (120) inclut d'éliminer la couche ARC (140).

4. Procédé selon les revendications 1, 2 ou 3, **caractérisé, de plus, en ce que** le carbone amorphe comporte des cendres de plasma d'O₂.

5. Procédé selon la revendication 1 dans lequel la couche de transfert (130) présente une épaisseur de 5 à 200 nm.

6. Procédé selon la revendication 1 consistant, de plus, à
configurer (45) la couche de résine photosensible (150) placée au-dessus de la couche ARC (140), la couche ARC étant une couche de SiON, et de la couche de transfert (130), la couche de transfert étant une couche de carbone amorphe (130) ;
graver (55, 65) la couche de SiON (140) et la couche de carbone amorphe (130) en utilisant la couche de résine photosensible configurée (150) comme un masque et exposer une couche contenant du métal (120) disposée au-dessous de la couche de carbone amorphe (130), la couche contenant du métal (120) étant l'absorbeur (120) ;
graver (75) la couche contenant du métal (120) en utilisant la couche de carbone amorphe (130) comme un masque ; et
éliminer (85) la couche de carbone amorphe (130).

7. Procédé selon la revendication 6 dans lequel graver (55, 65) la couche de SiON (140) et la couche de carbone amorphe (130) en utilisant la couche de résine photosensible configurée (150) comme un masque et exposer une couche contenant du métal (120) disposée au-dessous de la couche de carbone amorphe (130) incluent d'éliminer la couche de résine photosensible (150) pendant la gravure (75) de la couche de carbone amorphe (130).

8. Procédé selon la revendication 6 dans lequel la couche de résine photosensible (150) présente une épaisseur de 400 nm.

9. Procédé selon la revendication 6 dans lequel la couche de carbone amorphe (130) présente une épaisseur comprise approximativement entre 30 nm et 100 nm.

10. Procédé selon la revendication 6 dans lequel graver (75) la couche contenant du métal (120) en utilisant la couche de carbone amorphe (130) comme un masque inclut d'éliminer la couche de SiON (140).

## Patentansprüche

1. Verfahren zur Herstellung eines Retikels, wobei das Verfahren umfasst:
Abscheiden (15, 25, 35) eines Schichtstapels mit einem Substrat (110), einer Absorberschicht (120), einer Transferschicht (130), optional einer antireflektierenden (ARC) Beschichtung (140) und einer Fotolackschicht (150);
Strukturieren (45) der Fotolackschicht (150);
Ätzen (55, 65) der ARC-Beschichtung (140) und der Transferschicht (130);
Ätzen (75) der Absorberschicht (120); und
Entfernen (85) der Transferschicht (130), wobei die Transferschicht (130) amorphen Kohlenstoff enthält.

2. Verfahren nach Anspruch 1, wobei Ätzen (55, 65) der ARC-Beschichtung (140) und der Transferschicht (130) Entfernen der Fotolackschicht (150) umfasst.

3. Verfahren nach Anspruch 1, wobei Ätzen (75) der Absorberschicht (120) Entfernen der ARC-Beschichtung (140) umfasst.

4. Verfahren nach Anspruch 1, 2 oder 3, das ferner **dadurch gekennzeichnet ist, dass** Entfernen des amorphen Kohlenstoffs eine O₂-Plasmaveraschung umfasst.

5. Verfahren nach Anspruch 1, wobei die Transferschicht (130) eine Dicke von 5 bis 200 nm aufweist.

6. Verfahren nach Anspruch 1, das ferner umfasst:
Strukturieren (45) der Fotolackschicht (150), die über der ARC-Beschichtung (140), die eine SiON-Schicht ist, und über der Transferschicht (130) angeordnet ist, wobei die Transferschicht eine amorphe Kohlenstoffschicht (130) ist;
Ätzen (55, 65) der SiON-Schicht (140) und der amorphen Kohlenstoffschicht (130) unter Anwendung der strukturierten Fotolackschicht (150) als eine Maske, wobei eine metallenthaltende Schicht (120), die unter der amorphen Kohlenstoffschicht (130) liegt, freigelegt wird und wobei die metallenthaltende Schicht (120) die Absorberschicht (120) ist;
Ätzen (75) der metallenthaltenden Schicht (120) unter Anwendung der amorphen Kohlenstoffschicht (130) als eine Maske; und
Entfernen (85) der amorphen Kohlenstoffschicht (130).

7. Verfahren nach Anspruch 6, wobei Ätzen (55, 65) der SiON-Schicht (140) und der amorphen Kohlenstoffschicht (130) unter Anwendung der strukturierten Fotolackschicht (150) und Freilegen einer metallenthaltenden Schicht (120), die unter der amorphen Kohlenstoffschicht (130) liegt, Entfernen der Fotolackschicht (150) während des Ätzens (75) der amorphen Kohlenstoffschicht (130) umfasst.

8. Verfahren nach Anspruch 6, wobei die Fotolackschicht (150) eine Dicke von 400 nm aufweist.

9. Verfahren nach Anspruch 6, wobei die amorphe Kohlenstoffschicht (130) eine Dicke von ungefähr 30 nm bis 100 nm aufweist.

10. Verfahren nach Anspruch 6, wobei Ätzen (75) der metallenthaltenden Schicht (120) unter Anwendung der amorphen Kohlenstoffschicht (130) als eine Maske Entfernen der SiON-Schicht (140) umfasst.
